# FASCICULE DE BREVET EUROPEEN

(11) **EP 1 068 032 B1**
(45) Date de publication et mention de la délivrance du brevet: **03.07.2002**
(21) Numéro de dépôt: 99910425.0
(22) Date de dépôt: 25.03.1999
(51) Int. Cl.: B05D 7/24, C23C 16/26

(54) **RECIPIENT AVEC UN REVETEMENT EN MATIERE A EFFET BARRIERE ET PROCEDE ET APPAREIL POUR SA FABRICATION**
BEHÄLTER MIT EINER BESCHICHTUNG MIT SPERREIGENSCHAFTEN UND VERFAHREN ZU SEINER HERSTELLUNG
CONTAINER WITH MATERIAL COATING HAVING BARRIER EFFECT AND METHOD AND APPARATUS FOR MAKING SAME

(30) Priorité: 27.03.1998 FR 9803824
(43) Date de publication de la demande: 17.01.2001
(73) Titulaire: SIDEL, 76930 Octeville-sur-Mer (FR)
(72) Inventeur: DARRAS, David, F-76600 Le Havre (FR); RIUS, Jean-Michel, F-76133 Maneglise (FR); CHOLLET, Patrick, F-22300 Lannion (FR); BOUTROY, Naima, F-22560 Pleumeur-Bodou (FR); BELDI, Nasser, F-22700 Perros-Guirec (FR); OGE, Fabrice, F-22300 Lannion (FR)
(74) Mandataire: Gorrée, Jean-Michel
(86) Numéro de dépôt international: FR9900692
(87) Numéro de publication internationale: WO9949991

(56) Documents cités:
- EP-A- 0 575 299
- EP-A- 0 739 655
- EP-A- 0 773 166
- EP-A- 0 778 089
- WO-A-95/22413
- DE-A- 3 632 748
- DE-A- 4 316 349
- DE-A- 4 437 050
- US-A- 4 756 964
- DANZER T ET AL: "INFLUENCE OF SELECTED PROCESS PARAMETERS ON THE DEPOSITION OF POLYMER-LIKE AMORPHOUS HYDROGENATED CARBON FILMS IN GLOW DISCHARGES" THIN SOLID FILMS, vol. 219, no. 1 / 02, 30 octobre 1992, pages 119-128, XP000334912

## Description

La présente invention concerne les récipients tels que bouteilles ou flacons, de constitution hétérogène en une matière à effet barrière et une matière polymère.

Les récipients en matière polymère telle que le PET présentent l'inconvénient de ne pas être imperméables à certains gaz, notamment à l'oxygène et au gaz carbonique.

C'est ainsi que les boissons carbonatées perdent progressivement leur gaz carbonique qui migre dans l'atmosphère à travers la matière polymère : la durée de vie d'un liquide carbonaté contenu dans une bouteille en PET ne peut dépasser, commercialement, quelques semaines, ou au plus un petit nombre de mois (par exemple 4 à 6 mois).

C'est ainsi également que l'oxygène de l'atmosphère parvient, à travers la matière polymère, au contact du liquide contenu dans le récipient et risque d'oxyder celui-ci en dégradant ses caractéristiques : la durée de vie d'une bouteille en PET remplie de bière ne peut dépasser, commercialement, quelques semaines (par exemple 2 à 5 semaines).

Il est connu d'accroître l'effet barrière propre des matières polymères constitutives des récipients en doublant la paroi en polymère d'une couche d'une matière à effet barrière plus élevée.

On a ainsi proposé d'utiliser à cet effet des matières synthétiques en multicouche telles que celles réalisées à partir de polyamides aliphatiques et/ou de mélanges de diverses matières. Les récipients sont alors fabriqués à partir de préformes multicouches, dans lesquelles la couche de matière à effet barrière est enchâssée entre au moins deux couches de matière polymère (par exemple en PET). Des bouteilles de bière ainsi constituées voient leur durée de vie commerciale accrue sensiblement (par exemple jusqu'à 12 semaines).

Toutefois, un inconvénient majeur de ces récipients multi-couches réside dans le décollement des couches les unes des autres. En outre aussi bien la fabrication de la préforme que la fabrication du récipient à partir de la préforme par soufflage ou étirage-soufflage sont complexes, nécessitent des précautions et sont coûteuses.

On a également proposé de traiter les récipients en matière polymère par enduction externe d'une couche d'un matériau approprié, tel que ceux dénommés PVDC ou des résines thermodurcissables. Toutefois, le gain d'effet barrière ainsi obtenu reste faible et la présence du matériau d'enduction entraîne des difficultés pour le recyclage de la matière polymère de base.

En outre, toutes les solutions connues précitées maintiennent la matière polymère (par exemple du PET) au contact du liquide, et elles n'offrent donc pas de protection contre les inconvénients engendrés par ce contact : possibilité de migration de certains constituants du polymère dans le liquide, possibilité de réaction chimique du polymère avec le liquide, transfert d'acétaldéhyde dans le liquide, etc., autant de phénomènes susceptibles d'engendrer des problème d'organoleptie.

Il a également été proposé de déposer une couche d'un matériau à effet barrière, par exemple du carbone dur, sur une paroi en polymère par exemple en PET, en mettant en oeuvre un plasma (document US 5 041 303).

Le document EP 0 773 166 mentionne en outre la possibilité de former une telle couche de carbone sur la face intérieure de la paroi du récipient.

Une couche de carbone ainsi déposée permet certes de remédier à l'ensemble des inconvénients qui ont été énoncés plus haut.

Toutefois, il s'agit alors d'une couche relativement épaisse de carbone dur ou carbone de type diamant ("diamond-like carbon" ou DLC). La paroi d'un récipient ainsi constitué associe donc une couche interne en carbone dur DLC, qui présente une rigidité sensible, et une couche externe en matière polymère telle que du PET, qui présente une déformabilité sensible. En raison de leurs caractéristiques mécaniques différentes et incompatibles, il est fréquent que les deux couches de polymère et de carbone dur finissent par se désolidariser ou se disloquer.

D'une façon générale, la fabrication de récipients en matière polymère qui présentent un effet barrière par mise en oeuvre de l'une des techniques précitées est peu répandue en raison de la complexité de mise en oeuvre des différents procédés, des faibles cadences de production et des coûts importants de ces fabrications.

L'invention a essentiellement pour but de remédier simultanément à l'ensemble des problèmes ci-dessus évoqués, rencontrés avec les récipients à effet barrière amélioré actuellement connus, et de proposer un récipient offrant une protection efficace de son contenu tout en étant fabricable de façon industrielle, à l'aide de moyens peu complexes dans des conditions économiques acceptables.

A ces fins, selon un premier de ses aspects, l'invention concerne un récipient, tel que bouteille ou flacon, de constitution hétérogène en une matière à effet barrière et une matière polymère qui, étant constitué conformément à l'invention, se caractérise en ce que la matière à effet barrière consiste en un matériau carbone amorphe à tendance polymère, qui revêt un substrat en matière polymère. Le substrat est constitué par une ébauche du récipient qui possède déjà la forme finale du récipient.

Par matériau carbone amorphe à tendance polymère, on entend désigner du carbone contenant non seulement des liaisons CH et CH² déjà présentes dans le carbone dur, mais également des liaisons CH³ qui sont absentes dans le carbone dur (pour fixer les idées, les proportions des liaisons CH³, CH² et CH sont respectivement de 0, de 40 et de 60 dans le carbone dur et de 25,de 60 et de 15 dans le carbone amorphe à tendance polymère, tandis que les proportions des états électroniques sp³, sp² et sp sont respectivement de 68, de 30 et de 2 pour le carbone dur et de 53, de 45 et de 2 pour le carbone de type polymère).

Le choix d'un matériau carbone amorphe à tendance polymère permet de résoudre le problème provoqué par la rigidité du carbone dur ou DLC : en effet, les matériaux carbone amorphe à tendance polymère présentent une rigidité mécanique sensiblement moins élevée que celle du carbone dur et la déformabilité d'une couche d'un tel matériau est comparable à celle d'un matériau polymère tel que le PET : une paroi de récipient constituée conformément à l'invention par un tel matériau carbone amorphe à tendance polymère adhérant à un substrat en matériau polymère tel que du PET peut donc subir les déformations courantes sans qu'il en résulte un décollement de ces deux couches.

Certes les matériaux carbone amorphe à tendance polymère possèdent, de façon inhérente à leur structure physico-chimique, un coefficient de perméabilité moléculaire inférieur à celui du carbone dur employé jusqu'ici et on pensait que l'effet barrière qu'ils procurent est moins parfait. C'est du reste une raison pour laquelle ils avaient été écartés jusqu'à présent, et que les couches à effet barrière en carbone étaient constituées en carbone dur ou DLC. Or, de façon surprenante, les essais menés avec des matériaux carbone amorphe à tendance polymère ont montré que l'effet barrière obtenu dans certaines conditions opératoires est largement suffisant dans la pratique pour le conditionnement des liquides carbonatés ou des liquides oxydables.

On peut également envisager l'emploi de nanocomposites de type carbone (ou DLN) - c'est-à-dire de composés à double réseaux mutuellement imbriqués, stabilisés et aléatoires dont l'un est un réseau de carbone amorphe à tendance polymère (a-c:H, avec jusqu'à 50% de liaisons sp³) et l'autre peut être un réseau de silice stabilisé par l'oxygène (a-Si:O)- et de nanocomposites avec inclusion d'atomes de métal.

Le revêtement de matériau carbone amorphe à tendance polymère présente avantageusement une épaisseur inférieure à environ 3000 Å (au-delà, l'épaisseur trop importante confère à la couche carbonée une rigidité mécanique trop élevée risquant de conduire à sa rupture et/ou à son décollement), de préférence comprise entre 800 et 1500 Å.

On notera que le carbone amorphe de type polymère, bien qu'étant encore transparent dans les épaisseurs indiquées, présente une couleur ambrée, qui contribue à la protection contre les rayonnements ultraviolets (protection de la bière notamment). On a constaté que, dans certaines conditions opératoires, l'efficacité barrière aux ultra-violets de cette protection est fonction de l'épaisseur du revêtement et de façon très intéressante s'accroît fortement avec l'intensité lumineuse ambiante (facteur d'environ 8 dans l'obscurité, mais facteur d'environ 30 à la lumière du jour).

La matière polymère qui est, dans les applications pratiques, un polyéfine ou un polyester tel que du PET ou du PEN peut, en raison de la rigidité propre de la couche carbonée, voir son épaisseur réduite. A ce sujet, on notera également que le revêtement carboné contribue à réduire la déformation de la paroi du récipient sous l'action de la pression d'un liquide gazeux, tel qu'un liquide carbonaté. Le récipient conserve donc une forme stable et son volume intérieur demeure constant : il n'en résulte aucune modification de la composition du liquide qui y est renfermé.

Bien que le revêtement en matière à effet barrière puisse être disposé à l'extérieur de l'ébauche de récipient, il est toutefois préférable que ce revêtement constitue la couche interne du récipient de façon qu'il contribue à isoler le matériau polymère et le liquide contenu dans le récipient : l'effet barrière est alors étendu et rend impossible une éventuelle migration de constituants du polymère dans le liquide, une éventuelle réaction chimique entre des substances du polymère et le liquide, une éventuelle migration de l'acétaldéhyde dans le liquide, etc.

On insistera ici sur le fait que le fondement de la constitution d'un récipient conforme à l'invention repose sur l'établissement de liaisons chimiques entre les atomes de carbone superficiels du substrat polymère qui présentent une liaison chimique disponible et les atomes du matériau carboné qui sont amenés au contact du polymère avec une liaison chimique libre, prête à se combiner avec la liaison disponible des carbones superficiels du substrat polymère. Dans ces conditions, c'est par une liaison chimique, extrêmement puissante donc, que le revêtement en matériau carboné est lié au substrat polymère ; le matériau carboné ayant en outre la tendance polymère explicitée précédemment, la liaison chimique puissante s'accompagne toutefois d'une relative aptitude à la déformabilité du revêtement carboné, ces deux caractéristiques conjointes conduisant à une structure qui ne présente plus les inconvénients (décollage des couches notamment) des récipients antérieurs en carbone dur ou DLC.

Pour déposer le revêtement carboné avec des atomes de carbone présentant une liaison chimique libre prête à se lier avec celle d'un atome de carbone superficiel en polymère, on peut mettre en oeuvre un procédé de dépôt par plasma.

Ainsi, selon un deuxième de ses aspects, l'invention propose un procédé mettant en oeuvre un plasma avec excitation par onde électromagnétique pour former un récipient, tel que bouteille ou flacon, de constitution hétérogène en une matière à effet barrière et une matière polymère formant un substrat possédant la conformation dudit récipient à obtenir, caractérisé en ce qu'on revêt ladite matière polymère formant substrat avec une matière à effet barrière comportant un matériau carbone amorphe à tendance polymère en ayant recours aux étapes suivantes :
- on introduit dans une enceinte une ébauche du récipient en matière polymère formant le substrat précité,
- on injecte dans une chambre de réaction au moins un précurseur carboné à l'état gazeux sous très faible pression inférieure à 10 mbar, le précurseur étant choisi parmi les alcanes, les alcènes, les alcynes, les aromatiques ou une combinaison de certains de ceux-ci,
- on établit dans la chambre de réaction une excitation électromagnétique micro-onde dans le domaine UHF avec une puissance relativement faible propre à engendrer un plasma dans des conditions de température qui, d'une part, maintiennent le polymère à une température inférieure à celle de la transition vitreuse et qui, d'autre part, provoquent le dépôt d'un matériau carbone amorphe à tendance polymère.

Dans un premier mode possible de mise en oeuvre, l'ébauche de récipient en matière polymère est fermée pendant que le précurseur carboné gazeux est injecté dans l'enceinte qui constitue alors la chambre de réaction, ce grâce à quoi le revêtement carbone amorphe à tendance polymère est déposé sur la surface externe de l'ébauche de récipient.

Dans un second mode possible de mise en oeuvre, le précurseur carboné gazeux est introduit dans l'ébauche de récipient en matière polymère, qui constitue alors la chambre de réaction, en même temps qu'on crée dans l'ébauche de récipient une dépression prononcée, ce grâce à quoi on engendre la formation d'un plasma uniquement à l'intérieur de l'ébauche et le revêtement carbone amorphe à tendance polymère est déposé sur la surface interne de l'ébauche de récipient ; par ailleurs, pour éviter la déformation du récipient en raison du vide qui y règne, on provoque simultanément une dépression dans l'enceinte pour réduire le différentiel de pression entre l'intérieur et l'extérieur de l'ébauche. En outre, de préférence dans ce cas, l'enceinte présente une dimension transversale voisine de celle du corps de l'ébauche de récipient, de manière à épouser étroitement l'ébauche de récipient, pour nécessiter l'emploi de moyens de mise sous vide de puissance moindre.

Grâce aux dispositions caractérisant le procédé conforme à l'invention, on est en mesure de générer le dépôt d'un revêtement en matériau carbone amorphe à tendance polymère ayant la faible épaisseur requise inférieure à 3000 Å et notamment comprise entre 800 et 1500 Å, en un temps court de l'ordre de quelques secondes et n'excédant pas la vingtaine de secondes, avec une puissance micro-onde modeste de l'ordre de quelques centaines de watts (par exemple d'environ 200 à 600 W) entraînant une densité de puissance d'environ 0,5 à 2 watts par centimètres cube. Il en résulte que l'élévation correspondante de température dans le matériau polymère constituant l'ébauche de récipient et servant de substrat pour le dépôt (intérieur ou extérieur selon le cas) du revêtement carboné demeure relativement faible et inférieure à la température de transition vitreuse du polymère (environ 80°C pour le PET).

Ce sont ces conditions de formation du revêtement carboné sous l'action d'un plasma micro-onde sous faible pression (n'excédant pas quelques millibars et en pratique de l'ordre de 0,01 à 0,5 mbar) ou "plasma froid" qui conduisent à une structure carbonée amorphe à tendance polymère, c'est-à-dire constituée par ou comportant un réseau de carbone amorphe surhydrogéné, lequel possède les caractéristiques avantageuses citées plus haut.

Outre l'obtention d'un récipient à couche à effet barrière ayant une bonne tenue mécanique sur le substrat polymère, le procédé conforme à l'invention offre par ailleurs l'avantage notable de faciliter la fabrication de récipients stériles utilisables dans les chaînes de conditionnement aseptique.

Le plasma généré au cours du processus de dépôt du revêtement carboné peut s'avérer suffisant pour obtenir un nettoyage désiré de la surface interne de l'ébauche de récipient.

Pour l'obtention d'un degré d'aseptie élevé, on peut envisager de mettre en oeuvre un agent bactéricide préalablement pulvérisé sous forme de micro-gouttelettes ou introduit sous forme vapeur, par exemple grâce à un bulleur, sur la surface interne de l'ébauche de récipient (par exemple peroxyde d'hydrogène, acide phosphorique, vapeur d'eau, etc.) ; la génération subséquente d'un plasma dans les conditions précitées est susceptible de créer un milieu fortement réducteur (par exemple génération d'oxygène natif) qui est capable de réduire la contamination bactérienne initiale pour répondre aux exigences de stérilisation.

Pour la mise en oeuvre du procédé précédent, l'invention propose, selon un troisième de ses aspects, un appareil mettant en oeuvre un plasma avec excitation par onde électromagnétique pour former un récipient, tel que bouteille ou flacon, de constitution hétérogène en une matière à effet barrière et une matière polymère formant un substrat (ébauche de récipient) possédant la conformation dudit récipient à obtenir, cet appareil comportant un dispositif générateur de plasma, avec une enceinte pourvue de moyens d'injection d'un précurseur gazeux et des moyens d'excitation électromagnétique, lequel appareil se caractérise en ce que, pour revêtir ladite matière polymère formant substrat en une matière à effet barrière comportant un matériau carbone amorphe à tendance polymère, les moyens d'injection du précurseur sont raccordés à un générateur d'un précurseur à l'état gazeux choisi parmi les alcanes, les alcènes, les alcynes, les aromatiques, ou une combinaison de certains d'entre eux, en ce que, pour revêtir ladite matière polymère formant substrat en une matière à effet barrière comportant un matériau carbone amorphe à tendance polymère, les moyens d'injection débouchent dans l'enceinte et sont agencés pour délivrer le précurseur gazeux sous une très faible pression inférieure à 10 mbar, et en ce que les moyens d'excitation électromagnétiques sont propres à générer des micro-ondes dans le domaine UHF.

Dans un premier mode de réalisation, l'enceinte présente des dimensions sensiblement supérieures à celles de l'ébauche de récipient à traiter et les moyens d'injection débouchent dans l'enceinte à l'extérieur de l'ébauche de récipient, ce grâce à quoi, l'ébauche de récipient étant fermée, l'appareil génère un plasma à l'extérieur de l'ébauche de récipient et c'est sur la surface externe de l'ébauche du récipient que se dépose le revêtement en matériau carbone amorphe à tendance polymère.

Dans un second mode de réalisation, les moyens d'injection du précurseur gazeux débouchent à l'intérieur de l'ébauche de récipient disposée dans l'enceinte et il est prévu des moyens de pompage s'ouvrant dans l'ébauche de récipient et propres à engendrer dans celle-ci une dépression prononcée, ce grâce à quoi le plasma est généré à l'intérieur de l'ébauche de récipient et c'est sur la surface intérieure de l'ébauche de récipient que se dépose le revêtement en matériau carbone amorphe à tendance polymère. Pour éviter une déformation de l'ébauche en raison de la dépression régnant à l'intérieur, on crée simultanément une dépression à l'intérieur de l'enceinte pour réduire le différentiel de pression entre l'intérieur et l'extérieur de l'ébauche. Avantageusement alors, l'enceinte est munie d'un couvercle amovible d'obturation étanche agencé pour supporter l'injecteur des moyens d'injection du précurseur gazeux et l'orifice d'aspiration des moyens de pompage ; il comporte en outre des moyens de support propre à supporter une ébauche de récipient par le col de celle-ci en appliquant le buvant de ladite ébauche de récipient de façon étanche contre la face intérieure dudit couvercle, en entourant les susdits orifices d'aspiration et injecteur. De plus, il est souhaitable que les moyens de support soient déplaçables axialement pour amener l'ébauche de récipient contre la face intérieure du couvercle en coiffant les susdits orifices d'aspiration et injecteur préalablement au dépôt du revêtement ou en écarter le récipient achevé après le dépôt du revêtement.

De préférence, pour faciliter l'emploi des moyens de pompage et éviter d'avoir recours à des moyens surdimensionnés, l'enceinte présente une dimension transversale voisine de celle du corps de l'ébauche de récipient.

Grâce aux dispositions conformes à l'invention, en particulier grâce aux durées réduites de traitement, on est en mesure de mettre en oeuvre industriellement un processus de fabrication d'un récipient à couche à effet barrière qui permette de produire de tels récipients à une cadence compatible avec les exigences actuelles du conditionnement des liquides.

L'invention sera mieux comprise à la lecture de la description détaillée qui suit de certains modes de réalisation donnés uniquement à titre d'exemples non limitatifs. Dans cette description, on se réfère aux dessins annexés sur lesquels :
- les figures 1 à 3 illustrent de façon schématique, en coupe, respectivement trois modes de réalisation d'un appareil permettant de constituer un récipient comportant une couche de matériau à effet barrière conformément à l'invention, et
- la figure 4 est une vue en coupe d'un exemple de réalisation préféré de l'appareil de la figure 1 agencé en vue de la formation d'une couche de matériau à effet barrière située à l'intérieur du récipient.

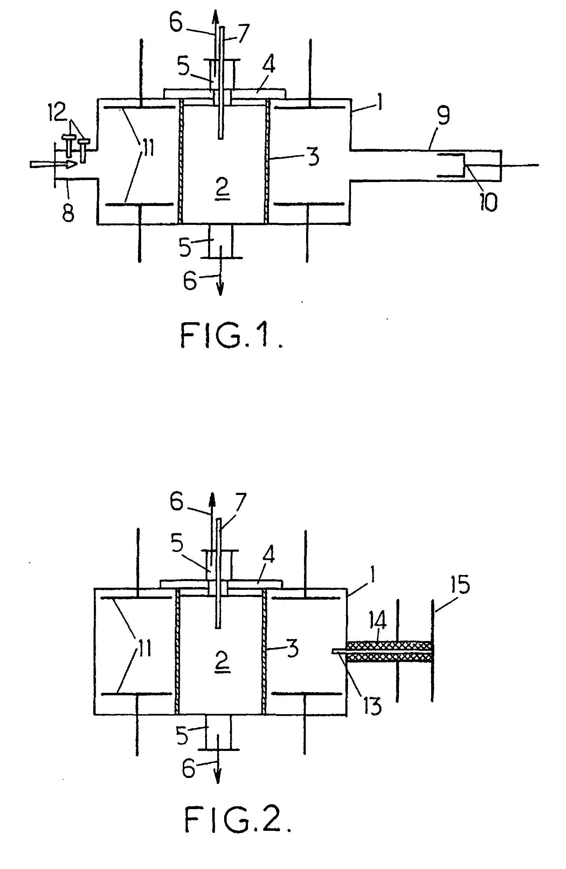

En se reportant tout d'abord à la figure 1, l'appareil comprend une cavité 1, à parois conductrices, par exemple métalliques, qui est dimensionnée en fonction de l'objet à traiter et du mode de couplage recherché et qui renferme une enceinte 2 définie par des parois 3 en un matériau transparent pour les micro-ondes électromagnétiques, par exemple en quartz.

L'enceinte 2 est fermée par exemple en haut par un couvercle amovible 4 permettant la mise en place de l'objet à traiter dans l'enceinte et son enlèvement après traitement.

Pour qu'un vide puisse y être engendré, l'enceinte 2 est raccordée à des moyens de pompage externes (non représentés) par l'intermédiaire d'au moins un raccord: sur la figure 1, deux raccords 5 sont prévus respectivement dans le fond et dans le couvercle 4 (pompage symbolisé par les flèches 6).

Pour l'injection, de préférence sous une pression inférieure à 1mbar, d'au moins un précurseur gazeux dans l'enceinte 2, il est prévu au moins un injecteur 7 raccordé à au moins un générateur de précurseur gazeux ou liquide (non montré), tel qu'un réservoir, un mélangeur ou un bulleur. L'injecteur 7 traverse le couvercle auquel il est fixé, par exemple en s'étendant coaxialement dans le raccord 5 des moyens de pompage.

La cavité 1 est connectée à un générateur de micro-ondes électromagnétiques (non représenté) par un guide d'onde 8 qui s'étend radialement par rapport à la paroi latérale de la cavité 1. Ce guide d'onde est muni de moyens de réglage, par exemple des vis plongeantes 12, permettant l'accord de la cavité. A l'opposé (diamétralement opposé si la cavité est cylindrique de révolution comme c'est en pratique le cas) s'étend un tronçon de guide d'onde 9 pourvu d'un piston d'accord 10 mobile axialement qui constitue un dispositif de court-circuit transversal.

Enfin, dans la cavité 1 sont disposées respectivement en haut et en bas deux plaques annulaires 11 entourant l'enceinte 2 et constituant des courts-circuits longitudinaux pour les micro-ondes.

Dans le cas où l'on cherche à déposer du carbone sur le substrat en matière polymère, c'est-à-dire sur la paroi de l'ébauche de récipient en matière polymère, le précurseur gazeux peut être choisi parmi les alcanes (par exemple le méthane), les alcènes, les alcynes (par exemple l'acétylène) et les aromatiques.

La pression au sein de la chambre de réaction (constituée soit par l'enceinte, soit par l'ébauche de récipient comme cela sera expliqué ultérieurement) doit être faible, de préférence inférieure à environ 10 mbar, en pratique de l'ordre de 0,01 à 0,5 mbar.

En outre, il est indispensable que l'échauffement subi par la matière polymère du substrat reste suffisamment faible pour que ne soit pas atteinte la température de transition vitreuse du polymère (qui par exemple est de l'ordre de 80°C pour le PET). Il est donc nécessaire de mettre en oeuvre, pour la réaction de dépôt, une puissance micro-onde peu importante, par exemple de quelques centaines de watts au maximum avec des micro-ondes de la gamme UHF (par exemple de l'ordre de 2,45 GHz).

Compte tenu des conditions de dépôt, notamment de la faible température de dépôt du carbone, on obtient un carbone amorphe fortement hydrogéné, contenant non seulement des radicaux CH et CH², mais aussi une fraction notable de radicaux CH³. Il s'agit donc d'un carbone à tendance polymère ou carbone "mou", qui présente une rigidité moins élevée que le carbone dur ou DLC. Cette couche de carbone à tendance polymère présente donc une capacité de déformation qui la rend apte à accompagner tant soit peu les déformations du polymère constitutif du substrat. Il en résulte donc un meilleur couplage mécanique du substrat polymère et du carbone et les risques de décollement se trouvent ainsi fortement réduits, voire éliminés.

Toutefois, il faut bien comprendre que, bien que présentant une rigidité moins élevée que le carbone dur ou DLC, le carbone à tendance polymère ou carbone "mou" conserve lui aussi une sensible rigidité qui, en tout état de cause, est sensiblement supérieure à celle du polymère constitutif du substrat. Ainsi il devient envisageable d'attribuer à la couche de carbone la fonction de conférer une partie de la rigidité intrinsèque du récipient achevé ; le substrat en polymère peut, alors, être déchargé d'une partie de la fonction de résistance mécanique au sein du récipient achevé. On peut ainsi réduire l'épaisseur du substrat en polymère et donc la quantité de polymère entrant dans la fabrication de chaque récipient.

Par ailleurs, la présence de la couche de carbone renforce la résistance mécanique du récipient et, de ce fait, réduit, voire supprime la capacité de déformation d'un récipient rempli d'un liquide fortement carbonate : la forme et donc le volume du récipient restent stables et on évite ainsi un dégazage partiel du liquide.

Bien entendu, les avantages qui viennent d'être mentionnés accompagnent celui, fondamental, indiqué précédemment et qui est recherché au premier degré, qui consiste en l'obtention d'un effet barrière s'opposant notamment aux échanges gazeux entre le liquide contenu dans le récipient et l'atmosphère.

Enfin, grâce aux moyens mis en oeuvre conformément à l'invention, on peut réaliser une vitesse de dépôt de plusieurs centaines d'angströms par seconde et obtenir des temps de traitement de l'ordre de quelques secondes qui sont alors tout-à-fait compatibles avec des processus de fabrication industrielle.

Bien entendu, d'autres modes de réalisation d'appareil peuvent être envisagés pour générer le plasma propre au dépôt de la couche de carbone amorphe à tendance polymère recherchée dans le cadre de la présente invention.

Ainsi, à la figure 2, en conservant le même agencement de la cavité 1 et de l'enceinte 2 (les mêmes références numériques sont conservées pour désigner les organes identiques à ceux de la figure 1), l'excitation micro-onde est ici obtenue à partir d'une antenne 13 qui pénètre radialement dans la cavité 1 à travers la paroi latérale de celle-ci et qui est raccordée par un conducteur coaxial 14 à un guide d'onde 15 en mode transversal.

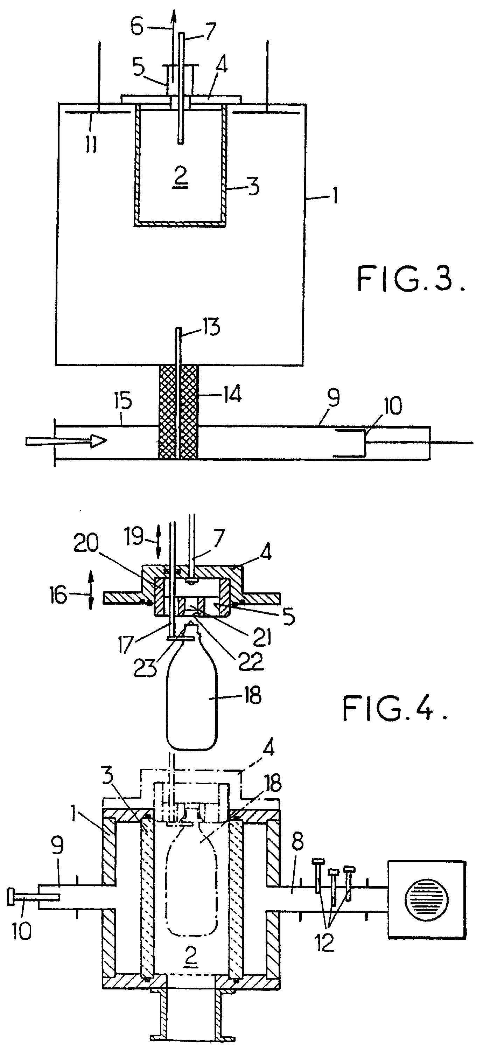

La figure 3 illustre un autre mode de réalisation à cavité micro-onde axiale à partir d'une antenne 13 qui est montée dans le fond de la cavité 1, sensiblement transversalement audit fond et approximativement coaxialement à l'enceinte 2. Le court-circuit longitudinal est procuré ici par la seule plaque annulaire supérieure 11, tandis qu'un seul orifice de pompage 5 est prévu dans l'enceinte 2.

Les divers modes de réalisation d'appareil qui viennent d'être exposés permettent le dépôt du matériau carboné sur la face externe de l'ébauche de récipient en matière polymère : l'enceinte 2 présente alors un volume notablement plus grand que celui de l'ébauche de récipient afin que le plasma puisse se développer, l'ébauche de récipient étant mise en place bouchée pour éviter un dépôt intérieur.

Toutefois, comme cela a été indiqué précédemment, une couche externe de matériau carboné ne procure qu'un effet barrière partiel, qui ne permet pas d'entraver les interactions entre le polymère du substrat et le contenu généralement liquide.

L'obtention d'un effet barrière total ne peut donc être procuré que par une couche à effet barrière disposé sur le substrat intérieurement au récipient. Le dépôt d'une telle couche intérieure nécessite un aménagement de l'appareil de traitement.

A la figure 4 est représentée une variante de l'appareil de la figure 1 agencé pour le dépôt d'une couche carbonée interne. L'enceinte 2 possède de préférence une conformation telle que sa dimension transversale ou diamétrale soit peu supérieure à celle de l'ébauche de récipient à traiter, pour faciliter la mise sous vide de l'enceinte décrite ci-après. Pour éviter une déformation de l'ébauche en raison de la dépression régnant à l'intérieur, on crée simultanément une dépression à l'intérieur de l'enceinte pour réduire, voire annuler le différentiel de pression entre l'intérieur et l'extérieur de l'ébauche.

Le couvercle 4, qui est mobile verticalement (double flèche 16) pour permettre la mise en place de l'ébauche de récipient et l'extraction du récipient traité, est traversé par un bras vertical 17 de support de l'ébauche de récipient 18 ; ce bras est mobile verticalement (double flèche 19) et éventuellement rotatif.

Le couvercle 4 comporte une garniture intérieure 20 munie d'un passage axial 21 dans lequel ou en regard duquel débouche l'injecteur 7 de précurseur gazeux. A son extrémité inférieure, le passage axial 21 est conformé en siège 22 propre à recevoir de façon sensiblement étanche le buvant 23 du goulot de l'ébauche de récipient 18 en vue d'un positionnement axial précis de l'ébauche de récipient. La garniture 20 comporte en outre une ouverture annulaire, traversée par le susdit bras de support 17, avec laquelle communique le passage central 22 ; cette ouverture forme l'orifice 5 d'aspiration en direction des moyens de pompage pour l'établissement du vide. Pour assurer les conditions propres à l'établissement du plasma dans l'ébauche de récipient seul, on établit dans celle-ci une dépression prononcée, en même temps qu'on crée dans l'enceinte la dépression de compensation susmentionnée.

Grâce à cet agencement, on est en mesure de créer un plasma dans l'ébauche de récipient qui constitue ainsi la chambre à réaction elle-même, ce qui permet un dépôt interne du matériau carboné.

A titre d'exemple, on a mis en oeuvre l'appareil de la figure 4 en utilisant l'acétylène en tant que précurseur gazeux introduit dans le goulot de l'ébauche de récipient par un injecteur de 4 mm de diamètre, avec un débit de 80 sccm et sous une pression de 0,25 mbar. La pression résiduelle à l'intérieur de l'ébauche est de l'ordre de 0,2 mbar et on a constaté qu'une pression résiduelle de 50 mbar à l'intérieur de l'enceinte s'avérait suffisante pour empêcher la déformation de l'ébauche dans ces conditions. L'excitation est procurée par des micro-ondes du domaine UHF ayant une fréquence de 2,45 GHz (soit une longueur d'onde λ = 12 cm dans le vide) ; la puissance micro-ondes est de l'ordre de 180 W. Dans ces conditions, on a pu effectuer un dépôt de carbone avec une vitesse de croissance de l'ordre de 250 Å/s, c'est-à-dire obtenir une couche ayant une épaisseur de l'ordre de 1500 Å en un temps d'environ 6 secondes.

Selon un second exemple, on a mis en oeuvre un appareil du type de la figure 4, en injectant dans l'ébauche de récipient de l'acéthylène sous un débit d'environ 160 sccm sous une pression d'environ 0,1 mbar. Dans ce cas, avec une puissance micro-ondes d'environ 350 W pour une bouteille d'un demi-litre, ou d'environ 500 W pour une bouteille d'un litre, on obtient une couche barrière efficace dans un temps d'environ 2 à 3 secondes.

La mise en oeuvre d'un plasma dans le processus de fabrication du récipient permet, selon les conditions de traitement (durée notamment), d'envisager la réalisation, de façon simple, d'un traitement de nettoyage ou d'aseptie (stérilisation) de l'intérieur du récipient dans les installations effectuant en ligne la fabrication du récipient, le remplissage et le bouchage en milieu aseptique.

Le plasma généré au cours du dépôt de la couche carbonée peut s'avérer suffisant pour obtenir un nettoyage de premier degré de la surface interne de l'ébauche.

Pour un traitement d'un niveau plus poussé, un simple plasma d'oxygène crée des espèces réactives, par exemple des métastables, de l'oxygène atomique ou moléculaire, qui sont capables, sous l'action de leurs énergies propres, de réduire la contamination bactérienne initiale dans une proportion suffisante pour répondre au critère de sanitation.

Ces traitements s'effectuent dans des temps inférieurs à la dizaine de secondes qui sont compatibles avec des installations industrielles.

Pour l'obtention d'une stérilisation de haut degré, on doit avoir recours à un agent bactéricide tel que le peroxyde d'hydrogène H₂O₂ sur lequel, après un temps de contact prédéterminé avec l'ébauche, on fait agir un plasma d'oxygène : les phénomènes physico-chimiques engendrés par le plasma dans le mélange peroxyde d'hydrogène-oxygène engendrent les espèces réactives mentionnées et autres qui sont fortement réductrices et peuvent avoir un fort pouvoir bactéricide.

Le traitement par plasma peut également être envisagé comme technique d'élimination d'un agent bactéricide tel que l'acide phosphorique qui est réducteur.

On peut ici souligner que, indépendamment de sa fonction bactéricide, le peroxyde d'hydrogène se comporte comme créateur de radicaux libres parmi les atomes de carbone du polymère qui sont présents à la surface du substrat : il en résulte à la surface du polymère un accroissement du nombre des radicaux libres prêts à accueillir des atomes de carbone déposés en surface, et donc un renforcement des liaisons chimiques établies entre le polymère et le carbone déposé à sa surface. Il peut donc être envisagé de faire précéder le dépôt en atmosphère plasma de la couche carbonée par une pulvérisation de peroxyde d'hydrogène sur la surface du substrat soumise ensuite à un plasma d'oxygène afin d'obtenir une meilleure adhérence de la couche de carbone au polymère.

## Revendications

1. Récipient, tel que bouteille ou flacon, de constitution hétérogène en une matière à effet barrière et une matière polymère, **caractérisé en ce que** la matière à effet barrière comporte un matériau carbone amorphe à tendance polymère, qui revêt un substrat en matière polymère.

2. Récipient selon la revendication 1, **caractérisé en ce que** la matière à effet barrière est un nanocomposite à base de carbone amorphe à tendance polymère.

3. Récipient selon la revendication 2, **caractérisé en ce que** la matière à effet barrière est un nanocomposite à base de carbone amorphe à tendance polymère avec inclusion d'atomes de métal.

4. Récipient selon l'une quelconque des revendications précédentes, **caractérisé en ce que** le revêtement en matière à effet barrière possède une épaisseur inférieure à environ 3000 Å.

5. Récipient selon la revendication 4, **caractérisé en ce que** le revêtement en matière à effet barrière possède une épaisseur comprise entre 50 et 1500 Å.

6. Récipient selon l'une quelconque des revendications précédentes, **caractérisé en ce que** la matière polymère est un polyoléfine, ou un polyester notamment du PET ou du PEN.

7. Récipient selon l'une quelconque des revendications précédentes, **caractérisé en ce que** le revêtement en matière à effet barrière est disposé sur le substrat à l'intérieur du récipient.

8. Récipient selon l'une quelconque des revendications 1 à 6, **caractérisé en ce que** le revêtement en matière à effet barrière est disposé sur le substrat à l'extérieur du récipient.

9. Procédé mettant en oeuvre un plasma avec excitation par onde électromagnétique pour former un récipient, tel que bouteille ou flacon, de constitution hétérogène en une matière à effet barrière et une matière polymère formant un substrat possédant la conformation dudit récipient à obtenir, **caractérisé en ce qu'**on revêt ladite matière polymère formant substrat avec une matière à effet barrière comportant un matériau carbone amorphe à tendance polymère en mettant en oeuvre les étapes suivantes :
- on introduit dans une enceinte (2), dans laquelle a été créé un vide poussé, une ébauche du récipient (18) constituée en matière polymère formant le substrat précité,
- on injecte dans une chambre de réaction (2, 18) au moins un précurseur carboné à l'état gazeux sous très faible pression, le précurseur étant choisi parmi les alcanes, les alcènes, les alcynes, les aromatiques ou une combinaison de certains de ceux-ci et
- on établit simultanément dans la chambre de réaction une excitation électromagnétique micro-onde dans le domaine UHF avec une puissance relativement faible propre à engendrer un plasma dans des conditions de température qui, d'une part, maintiennent le polymère à une température inférieure à celle de la transition vitreuse et qui, d'autre part, provoquent le dépôt d'un matériau carbone amorphe à tendance polymère.

10. Procédé selon la revendication 9, **caractérisé en ce que** l'ébauche de récipient(18) en matière polymère est fermée pendant que le précurseur carboné gazeux est injecté dans l'enceinte (2) à l'extérieur de l'ébauche, le volume compris entre l'enceinte et l'extérieur de l'ébauche constituant la chambre de réaction, ce grâce à quoi le revêtement en matériau carbone amorphe à tendance polymère est formé sur la surface externe de l'ébauche de récipient.

11. Procédé selon la revendication 9, **caractérisé en ce que** le précurseur carboné gazeux est introduit dans l'ébauche de récipient (18) en matière polymère qui constitue alors la chambre de réaction, en même temps qu'on crée dans l'ébauche de récipient une dépression prononcée, ce grâce à quoi le plasma se forme uniquement à l'intérieur de l'ébauche et le revêtement en matériau carbone amorphe à tendance polymère est déposé sur la surface interne de l'ébauche de récipient, et on crée simultanément une dépression dans l'enceinte pour réduire le différentiel de pression entre l'intérieur et l'extérieur de l'ébauche.

12. Procédé selon la revendication 11, **caractérisé en ce que** l'enceinte (2) présente une dimension transversale voisine de celle du corps de l'ébauche de récipient (18), de manière à épouser étroitement l'ébauche de récipient, afin de faciliter la formation du vide dans l'enceinte.

13. Procédé selon l'une quelconque des revendications 9 à 12, **caractérisé en ce que** le précurseur gazeux est injecté sous une pression inférieure à 1 mbar.

14. Procédé selon l'une quelconque des revendications 9 à 13, **caractérisé en ce qu'**avant la formation du revêtement intérieur en matériau carbone amorphe à tendance polymère, on forme dans l'ébauche de récipient (18) un plasma d'oxygène propre à engendrer de l'oxygène natif, afin de nettoyer l'ébauche de récipient.

15. Procédé selon l'une quelconque des revendications 9 à 13, **caractérisé en ce qu'**avant la formation du revêtement intérieur en matériau carbone amorphe à tendance polymère, on pulvérise dans l'ébauche de récipient (18) un agent bactéricide, puis on établit un plasma d'oxygène,
ce grâce à quoi le plasma engendre la formation d'un milieu fortement réducteur propre à réduire la contamination bactérienne.

16. Appareil mettant en oeuvre un plasma avec excitation par onde électromagnétique pour former un récipient, tel que bouteille ou flacon, de constitution hétérogène en une matière à effet barrière et une matière polymère formant un substrat (ébauche de récipient (18)) possédant la conformation dudit récipient à obtenir, cet appareil comportant un dispositif générateur de plasma, avec une enceinte (2) pourvue de moyens (7) d'injection d'un précurseur gazeux et des moyens d'excitation électromagnétique (8-12),
**caractérisé en ce que**, pour revêtir ladite matière polymère formant substrat avec une matière à effet barrière comportant un matériau carbone amorphe à tendance polymère, les moyens (7) d'injection du précurseur sont raccordés à un générateur d'un précurseur à l'état gazeux choisi parmi les alcanes, les alcènes, les alcynes, les aromatiques, ou une combinaison de certains d'entre eux, et les moyens d'injection sont agencés pour délivrer le précurseur gazeux sous une très faible pression, et les moyens d'excitation électromagnétiques (8-12) sont propres à générer des micro-ondes dans le domaine UHF.

17. Appareil selon la revendication 16, **caractérisé en ce que** l'enceinte (2) présente des dimensions sensiblement supérieures à celles de l'ébauche de récipient (18) à traiter et **en ce que** les moyens d'injection débouchent dans l'enceinte (2) à l'extérieur de l'ébauche de récipient (18),
ce grâce à quoi, l'ébauche de récipient étant fermée, l'appareil génère un plasma à l'extérieur de l'ébauche de récipient et c'est sur la surface externe de l'ébauche du récipient que se dépose le revêtement en matériau carbone amorphe à tendance polymère.

18. Appareil selon la revendication 16, **caractérisé en ce que** les moyens (7) d'injection du précurseur gazeux débouchent à l'intérieur de l'ébauche de récipient (18) disposée dans l'enceinte (2),
**en ce qu'**il est prévu des moyens de pompage (6) s'ouvrant dans l'ébauche de récipient (18) et propres à engendrer dans celle-ci une dépression prononcée, ce grâce à quoi le plasma est généré à l'intérieur de l'ébauche de récipient qui constitue une chambre de réaction et c'est sur la surface intérieure de l'ébauche de récipient que se dépose le revêtement en matériau carbone amorphe à tendance polymère,
et
**en ce que** les moyens de pompage (6) sont par ailleurs agencés pour engendrer simultanément dans l'enceinte (2) une dépression afin de réduire le différentiel de pression entre l'intérieur et l'extérieur de l'ébauche.

19. Appareil selon la revendication 18, **caractérisé en ce que** l'enceinte (2) est munie d'un couvercle amovible (4) d'obturation étanche agencé pour supporter l'injecteur (7) des moyens d'injection du précurseur gazeux et l'orifice (5) d'aspiration des moyens de pompage
et **en ce qu'**il comporte en outre des moyens (17) de support propres à supporter une ébauche de récipient (18) par le col de celle-ci en appliquant le buvant (23) de ladite ébauche de récipient de façon étanche contre la face intérieure (22) dudit couvercle, en entourant les susdits orifices d'aspiration et l'injecteur.

20. Appareil selon la revendication 19, **caractérisé en ce que** les moyens de support (17) sont déplaçables axialement (19) pour amener l'ébauche de récipient contre la face intérieure du couvercle (4) en coiffant les susdits orifices d'aspiration et l'injecteur préalablement au dépôt du revêtement ou en écarter le récipient achevé après le dépôt du revêtement.

21. Appareil selon les revendications 16 à 20, **caractérisé en ce que** les moyens d'excitation à micro-ondes comprennent un guide d'ondes (8) raccordé radialement à une cavité (1) entourant l'enceinte (2), ladite cavité (1) étant pourvue de moyens (11) de court-circuit longitudinal entourant ladite enceinte et le guide d'onde étant pourvu de moyens (10) de court-circuit transversal.

22. Appareil selon l'une quelconque des revendications 18 à 21, **caractérisé en ce que** l'enceinte (2) présente une dimension transversale voisine de celle du corps de l'ébauche de récipient (18).

23. Appareil selon l'une quelconque des revendications 16 à 20, **caractérisé en ce que** les moyens d'excitation à micro-ondes comprennent une antenne (13) raccordée à un guide d'onde (15) et disposée radialement dans une cavité (1) entourant l'enceinte (2), ladite cavité (1) étant pourvue de moyens de court-circuit longitudinal (11).

24. Appareil selon l'une quelconque des revendications 16 à 20, **caractérisé en ce que** les moyens d'excitation à micro-ondes comprennent une antenne (13) raccordée à un guide d'onde (15) et disposée coaxialement dans une cavité (1) entourant l'enceinte (2), ladite cavité (1) étant pourvue de moyens de court-circuit longitudinal (11).

## Patentansprüche

1. Behälter wie etwa eine Flasche oder ein Flakon mit heterogenem Aufbau aus einem Material mit einem Sperreffekt und einem polymeren Material, **dadurch gekennzeichnet, daß** das Material mit Sperreffekt ein amorphes Kohlenstoffmaterial mit polymerer Tendenz umfaßt, das ein Substrat aus einem polymeren Material beschichtet.

2. Behälter nach Anspruch 1, **dadurch gekennzeichnet, daß** das Material mit Sperreffekt ein Nano-Kompositwerkstoff auf Basis von amorphem Kohlenstoff mit polymerer Tendenz ist.

3. Behälter nach Anspruch 2, **dadurch gekennzeichnet, daß** das Material mit Sperreffekt eine Nanozusammensetzung auf Basis von amorphem Kohlenstoff mit polymerer Tendenz und mit Einschluß von metallischen Atomen ist.

4. Behälter nach einem der vorhergehenden Ansprüche, **dadurch gekennzeichnet, daß** die Beschichtung aus Material mit Sperreffekt eine Dicke von weniger als ca. 3000 Å aufweist.

5. Behälter nach Anspruch 4, **dadurch gekennzeichnet, daß** die Beschichtung aus Material mit Sperreffekt eine Dicke von zwischen 50 und 1500 Å aufweist.

6. Behälter nach einem der vorhergehenden Ansprüche, **dadurch gekennzeichnet, daß** das polymere Material ein Polyolefin oder ein Polyester, insbesondere PET oder PEN ist.

7. Behälter nach einem der vorhergehenden Ansprüche, **dadurch gekennzeichnet, daß** die Beschichtung aus Material mit Sperreffekt auf dem Substrat im Inneren des Behälters angeordnet ist.

8. Behälter nach einem der Ansprüche 1 bis 6, **dadurch gekennzeichnet, daß** die Beschichtung aus Material mit Sperreffekt auf dem Substrat auf der Außenseite des Behälters angeordnet ist.

9. Verfahren unter Anwendung eines Plasmas mit Anregung durch elektromagnetische Wellen zur Ausbildung eines Behälters wie etwa einer Flasche oder eines Flakons mit heterogenem Aufbau aus einem Material mit einem Sperreffekt und einem polymeren Material mit der Formgebung des herzustellenden Behälters, das ein Substrat darstellt, **dadurch gekennzeichnet, daß** das ein Substrat darstellende polymere Material mit einem Material mit einem Sperreffekt beschichtet wird, welches ein amorphes Kohlenstoffmaterial mit polymerer Tendenz umfaßt, unter Anwendung der folgenden Schritte:
- Einführen eines aus polymerem Material bestehenden und das Substrat darstellenden Behälter-Vorformlings (18) in ein Gehäuse (2), in dem ein Hochvakuum hergestellt wurde,
- Einspritzen von mindestens einem kohlenstoffhaltigen Vorläufermaterial im gasförmigen Zustand unter sehr geringem Druck in eine Reaktionskammer (2, 18), wobei das Vorläufermaterial unter den Alkanen, Alkenen, Alkynen, den Aromaten, oder einer Kombination von bestimmten von diesen ausgewählt ist, und
- gleichzeitiges Herstellen in der Reaktionskammer einer Anregung durch elektromagnetische Mikrowellen im UHF-Bereich mit einer ausreichend geringen Leistung, die zum Erzeugen eines Plasmas unter Temperaturbedingungen geeignet ist, welche einerseits das Polymer auf einer Temperatur unter der Glasübergangstemperatur halten und andererseits die Ablagerung eines amorphen Kohlenstoffmaterials mit polymerer Tendenz hervorrufen.

10. Verfahren nach Anspruch 9, **dadurch gekennzeichnet, daß** der Behälter-Vorformling (18) aus polymerem Material verschlossen ist, während das gasförmige kohlenstoffhaltige Vorläufermaterial in dem Gehäuse (2) auf das Äußere des Vorformlings aufgespritzt wird, wobei das zwischen dem Gehäuse und der Außenseite des Vorformlings befindliche Volumen die Reaktionskammer darstellt, infolgedessen die Beschichtung aus amorphem Kohlenstoffmaterial mit polymerer Tendenz auf der Außenfläche des Behälter-Vorformlings ausgebildet wird.

11. Verfahren nach Anspruch 9, **dadurch gekennzeichnet, daß** das gasförmige kohlenstoffhaltige Vorläufermaterial in den Behälter-Vorformling (18) aus polymerem Material, der dann die Reaktionskammer darstellt, gleichzeitig mit der Erzeugung eines ausgeprägten Unterdrucks im Behälter-Vorformling eingeführt wird, infolgedessen sich das Plasma nur im Inneren des Vorformlings bildet, und die Beschichtung aus amorphem Kohlenstoffmaterial mit polymerer Tendenz auf die Innenfläche des Behälter-Vorformlings aufgebracht wird, und gleichzeitig ein Unterdruck in dem Gehäuse erzeugt wird, um die Druckdifferenz zwischen dem Inneren und der Außenseite des Vorformlings zu verringern.

12. Verfahren nach Anspruch 11, **dadurch gekennzeichnet, daß** das Gehäuse (2) eine Querabmessung ähnlich derjenigen des Körpers des Behälter-Vorformlings (18) aufweist, so daß sie dem Behälter-Vorformling eng folgt, um die Ausbildung des Vakuums im Gehäuse zu erleichtern.

13. Verfahren nach einem der Ansprüche 9 bis 12, **dadurch gekennzeichnet, daß** das gasförmige Vorläufermaterial unter einem Druck von weniger als 1 mbar eingespritzt wird.

14. Verfahren nach einem der Ansprüche 9 bis 13, **dadurch gekennzeichnet, daß** vor der Ausbildung der Innenbeschichtung aus amorphem Kohlenstoffmaterial mit polymerer Tendenz im Behälter-Vorformling (18) ein Sauerstoffplasma gebildet wird, das dazu geeignet ist, nativen Sauerstoff zu erzeugen, um den Behälter-Vorformling zu reinigen.

15. Verfahren nach einem der Ansprüche 9 bis 13, **dadurch gekennzeichnet, daß** vor der Ausbildung der Innenbeschichtung aus amorphem Kohlenstoffmaterial mit polymerer Tendenz im Behälter-Vorformling (18) ein Bakterizid versprüht und daraufhin ein Sauerstoffplasma gebildet wird, infolgedessen das Plasma die Bildung eines stark reduzierenden Milieus hervorruft, die dazu geeignet ist, bakterielle Kontaminierung zu veringern.

16. Vorrichtung, welche ein Plasma mit Anregung durch elektromagnetische Wellen anwendet, zur Bildung eines Behälters wie etwa einer Flasche oder eines Flakons mit heterogenem Aufbau aus einem Material mit einem Sperreffekt und einem polymeren Material, welches ein Substrat (Behälter-Vorformling (18)) mit der Formgebung des herzustellenden Behälters darstellt, wobei die Vorrichtung eine Plasmaerzeugungseinrichtung aufweist, mit einem Gehäuse (2), das mit Mitteln (7) zum Einspritzen eines gasförmigen Vorläufermaterials und Mitteln (8-12) zur elektromagnetischen Anregung versehen ist,
**dadurch gekennzeichnet, daß** zum Beschichten des das Substrat bildenden polymeren Materials mit einem Material mit Sperreffekt, welches ein amorphes Kohlenstoffmaterial mit polymerer Tendenz umfaßt, die Mittel (7) zum Einspritzen des Vorläufermaterials an eine Einrichtung zum Erzeugen eines Vorläufermaterials im gasförmigen Zustand angeschlossen sind, das unter den Alkanen, Alkenen, Alkynen, den Aromaten, oder einer Kombination von bestimmten von diesen ausgewählt ist, und die Einspritzmittel zum Zuführen des gasförmigen Vorläufermaterials unter einem sehr geringen Druck konzipiert sind, und die Mittel (8-12) zur elektromagnetischen Anregung zum Erzeugen von Mikrowellen im UHF-Bereich geeignet sind.

17. Vorrichtung nach Anspruch 16, **dadurch gekennzeichnet, daß** das Gehäuse (2) Abmessungen aufweist, die deutlich größer als diejenigen des zu behandelnden Behälter-Vorformlings (18) sind, sowie dadurch, daß die Einspritzmittel außerhalb des Behälter-Vorformlings (18) in das Gehäuse (2) münden, infolgedessen, da der Behälter-Vorformling geschlossen ist, die Vorrichtung ein Plasma außerhalb des Behälter-Vorformlings erzeugt, und sich die Beschichtung aus amorphem Kohlenstoffmaterial mit polymerer Tendenz auf der Außenfläche des Behälter-Vorformlings ablagert.

18. Vorrichtung nach Anspruch 16, **dadurch gekennzeichnet, daß** die Mittel (7) zum Einspritzen des gasförmigen Vorläufermaterials in das Innere des im Gehäuse (2) angeordneten Behälter-Vorformlings (18) münden, dadurch, daß Pumpmittel (6) vorgesehen sind, die auf das Innere des Behälter-Vorformlings (18) hin offen sind und dazu geeignet sind, in diesem einen ausgeprägten Unterdruck zu erzeugen, infolgedessen das Plasma im Inneren des Behälter-Vorformlings erzeugt wird, der eine Reaktionskammer darstellt, und die Beschichtung aus amorphem Kohlenstoffmaterial mit polymerer Tendenz sich auf der Innenfläche des Behälter-Vorformlings ablagert,
sowie
**dadurch, daß** die Pumpmittel (6) des weiteren dazu konzipiert sind, gleichzeitig im Gehäuse (2) einen Unterdruck zu erzeugen, um die Druckdifferenz zwischen dem Inneren und der Außenseite des Vorformlings zu reduzieren.

19. Vorrichtung nach Anspruch 18, **dadurch gekennzeichnet, daß** das Gehäuse (2) mit einem abnehmbaren Deckel (4) zum dichten Verschließen versehen ist, der dazu konzipiert ist, die Einspritzeinrichtung (7) der Mittel zum Einspritzen des gasförmigen Vorläufermaterials und die Ansaugöffnung (5) der Pumpmittel zu tragen, sowie dadurch, daß sie des weiteren Tragemittel (17) aufweist, die geeignet sind, einen Behälter-Vorformling bei seinem Hals zu tragen durch dichtendes Anlegen der Halsöffnung (23) des Behälter-Vorformlings gegen die Innenfläche (22) des Deckels, wobei die Halsöffnung die Ansaugöffnungen und die Einspritzeinrichtung umgibt.

20. Vorrichtung nach Anspruch 19, **dadurch gekennzeichnet, daß** die Tragemittel (17) in Axialrichtung (19) verfahrbar sind, um den Behälter-Vorformling vor dem Aufbringen der Beschichtung an die Innenfläche des Deckels (4) zu führen, so daß er die Ansaugöffnung und die Einspritzvorrichtung abdeckt, bzw. um den fertiggestellten Behälter nach Aufbringen der Beschichtung davon zu entfernen.

21. Vorrichtung nach den Ansprüchen 16 bis 20, **dadurch gekennzeichnet, daß** die Mikrowellen-Anregungsmittel einen Wellenleiter (8) aufweisen, der in Radialrichtung an einen das Gehäuse (2) umgebenden Hohlraum (1) angeschlossen ist, wobei der Hohlraum (1) mit Mitteln (11) für den Längsschluß versehen ist, welche das Gehäuse umgeben, und der Wellenleiter mit Mitteln (10) für den Querschluß versehen ist.

22. Vorrichtung nach einem der Ansprüche 18 bis 21, **dadurch gekennzeichnet, daß** das Gehäuse (2) eine Querabmessung ähnlich derjenigen des Körpers des Behälter-Vorformlings (18) aufweist.

23. Vorrichtung nach einem der Ansprüche 16 bis 20, **dadurch gekennzeichnet, daß** die Mikrowellen-Anregungsmittel eine Antenne (13) aufweisen, die an einen Wellenleiter (15) angeschlossen und in Radialrichtung in einem das Gehäuse (2) umgebenden Hohlraum (1) angeordnet ist, wobei der Hohlraum (1) mit Mitteln (11) für den Längsschluß versehen ist.

24. Vorrichtung nach einem der Ansprüche 16 bis 20, **dadurch gekennzeichnet, daß** die Mikrowellen-Anregungsmittel eine Antenne (13) aufweisen, die an einen Wellenleiter (15) angeschlossen und koaxial in einem das Gehäuse (2) umgebenden Hohlraum (1) angeordnet ist, wobei der Hohlraum (1) mit Mitteln (11) für den Längsschluß versehen ist.

## Claims

1. A container, such as a bottle or flask, made heterogeneously from a material with a barrier effect and a polymer material, **characterised in that** the material with a barrier effect is an amorphous carbon material with a polymer tendency which is applied as a coating on a substrate of polymer material.

2. A container as claimed in claim 1, **characterised in that** the material with a barrier effect is a nano-composite based on amorphous carbon with a polymer tendency.

3. A container as claimed in claim 2, **characterised in that** the material with the barrier effect is a nano-composite based on an amorphous carbon with a polymer tendency incorporating metal atoms.

4. A container as claimed in any one of the preceding claims, **characterised in that** the coating of material with the barrier effect is less than about 3000 Å thick.

5. A container as claimed in claim 4, **characterised in that** the coating of material with a barrier effect is between 50 and 1500 Å thick.

6. A container as claimed in any one of the preceding claims, **characterised in that** the polymer material is a polyolefin or a polyester, in particular PET or PEN.

7. A container as claimed in any one of the preceding claims, **characterised in that** the coating of material with a barrier effect is applied to the substrate inside the container.

8. A container as claimed in any one of claims 1 to 6, **characterised in that** the coating of material with a barrier effect is applied to the substrate on the exterior of the container.

9. A method implementing a plasma excited by an electromagnetic wave to form a container, such as a bottle or flask, made heterogeneously from a material with a barrier effect and a polymer material forming a substrate conforming to the shape of said container to be produced, **characterised in that** said polymer material forming the substrate is coated with a material with a barrier effect comprising an amorphous carbon material with a polymer tendency by implementing the following steps:
- a blank of the container (18) made from a polymer material forming the above-mentioned substrate is placed in an enclosure (2), in which a high vacuum is created,
- at least one carbon precursor in the gaseous state is injected into the reaction chamber (2, 18) at a very low pressure, the precursor being selected from the alkane, alkene, alkyne and aromatic compounds or a combination of some of them, and
- simultaneously an UHF range electromagnetic microwave excitation is generated in the reaction chamber, at a relatively low power sufficient to generate a plasma under temperature conditions which will maintain the polymer at a temperature below the glass transition temperature, on the one hand, and which will cause an amorphous carbon material with a polymer tendency to be deposited, on the other.

10. A method as claimed in claim 9, **characterised in that** the container blank (18) made from polymer material is closed whilst the gaseous carbon precursor is being injected into the enclosure (2) onto the exterior of the blank, the volume between the enclosure and the exterior of the blank being the reaction chamber, whereby the coating of amorphous carbon material with a polymer tendency is formed on the external surface of the container blank.

11. A method as claimed in claim 9, **characterised in that** the gaseous carbon precursor is introduced into the container blank (18) made from polymer material, which then is the reaction chamber, at the same time as a pronounced vacuum is created inside the container blank, whereby the plasma is formed in the interior of the blank only and the coating of amorphous carbon with a polymer tendency is deposited on the internal surface of the container blank, and a vacuum is simultaneously created in the enclosure in order to reduce the pressure differential between the interior and the exterior of the blank.

12. A method as claimed in claim 11, **characterised in that** the enclosure (2) is of a transverse dimension close to that of the body of the container blank (18) so as to conform closely to the container blank in order to make it easier to create a vacuum in the enclosure.

13. A method as claimed in anyone of claims 9 to 12, **characterised in that** the gaseous carbon precursor is injected at a pressure of less than 1 mbar.

14. A method as claimed in any one of claims 9 to 13, **characterised in that** before the internal coating of amorphous carbon material with a polymer tendency is formed, an oxygen plasma is formed inside the container blank (18) conducive to generating native oxygen in order to clean the container blank.

15. A method as claimed in anyone of claims 9 to 13, **characterised in that** before the internal coating of amorphous carbon material with a polymer tendency is formed, a bactericidal agent is sprayed inside the container blank (18), after which an oxygen plasma is formed,
whereby the plasma generates a highly reductive medium conducive to reducing bacterial contamination.

16. An apparatus implementing a plasma excited by electromagnetic wave to form a container, such as a bottle or flask, made heterogeneously from a material with a barrier effect and a polymer material forming a substrate (container blank (18)) having the shape of said container to be produced, said apparatus comprising a plasma-generating device with an enclosure (2) fitted with means (7) for injecting a gaseous precursor and electromagnetic excitation means (8-12),
**characterised in that**, in order to coat said polymer material forming the substrate with a material having a barrier effect comprising an amorphous carbon material with a polymer tendency, the means (7) for injecting the precursor are connected to a means for generating a precursor in the gaseous state selected from the alkane, alkene, alkyne and aromatic compounds or a combination of some of them, and injection means are designed to deliver the gaseous precursor at a very low pressure, and the electromagnetic excitation means (8-12) are provided to generate microwaves in the UHF range.

17. An apparatus as claimed in claim 16, **characterised in that** the enclosure (2) is of dimensions substantially larger than those of the container blank (18) to be treated and **in that** the injection means open into the enclosure (2) outside the container blank (18),
whereby, the container blank being closed, the apparatus generates a plasma outside the container blank and it is on the external surface of the container blank that the coating of amorphous carbon material with a polymer tendency is deposited.

18. An apparatus as claimed in claim 16, **characterised in that** the means (7) for injecting the gaseous precursor opens into the inside of the container blank (18) placed inside the enclosure (2),
**in that** it is provided with pumping means (6) opening into the container blank (18) and capable of generating a pronounced vacuum therein, whereby the plasma is generated inside the container blank which is a reaction chamber and it is on the internal surface of the container blank that the coating of amorphous carbon material with a polymer tendency is deposited,
and
**in that** the pumping means (6) are also arranged so as to generate a vacuum in the enclosure (2) simultaneously in order to reduce the pressure differential between the interior and the exterior of the blank.

19. An apparatus as claimed in claim 18, **characterised in that** the enclosure (2) is provided with a removable cover (4) providing a sealed closure designed to support the injector (7) of the means for injecting the gaseous precursor and the suction orifice (5) of the pumping means
and **in that** it also has means (17) designed to support a container blank (18) by the neck thereof, whilst applying the lip (23) of said container blank in a tight seal against the internal face (22) of said cover, surrounding said suction orifices and the injector.

20. An apparatus as claimed in claim 19, **characterised in that** the support means (17) can be axially displaced (19) in order to apply the container blank against the internal face of the cover (4) capping said suction orifices and injector prior to depositing the coating or to remove the finished container therefrom after the coating has been deposited.

21. An apparatus as claimed in claims 16 to 20, **characterised in that** the microwave excitation means comprise a waveguide (8) radially connected to a cavity (1) surrounding the enclosure (2), said cavity (1) being provided with longitudinal short-circuit means (11) which surround said enclosure and the waveguide being provided with transverse short-circuit means (10).

22. An apparatus as claimed in any one of claims 18 to 21, **characterised in that** the enclosure (2) has a transverse dimension close to that of the body of the container blank (18).

23. An apparatus as claimed in any one of claims 16 to 20, **characterised in that** the microwave excitation means comprise antenna (13) connected to a waveguide (15) and disposed radially in a cavity (1) surrounding the enclosure (2), said cavity (1) being provided with longitudinal short-circuit means (11).

24. An apparatus as claimed in any one of claims 16 to 20, **characterised in that** the microwave excitation means comprise an antenna (13) connected to a waveguide (15) and coaxially disposed in a cavity (1) surrounding the enclosure (2), said cavity (1) being provided with longitudinal short-circuit means (11).
